# EUROPÄISCHE PATENTSCHRIFT

(11) **EP 0 676 846 B1**
(45) Veröffentlichungstag und Bekanntmachung des Hinweises auf die Patenterteilung: **17.06.1998**
(21) Anmeldenummer: 95104994.9
(22) Anmeldetag: 04.04.1995
(51) Int. Cl.: H02H 11/00, H03K 17/567, H03K 17/10

(54) **Schalter mit einem als Bipolartransistor ausgebildeten ersten Schaltelement**
Switch with a bipolar transistor as first switching element
Commutateur réalisé avec transistor bipolaire comme premier élément de commutation

(30) Priorität: 09.04.1994 DE 4412274
(43) Veröffentlichungstag der Anmeldung: 11.10.1995
(73) Patentinhaber: TEMIC TELEFUNKEN microelectronic GmbH, 74072 Heilbronn (DE)
(72) Erfinder: Hammel, Hermann, D-74585 Rot am See (DE); Häfner, Horst, D-74080 Heilbronn (DE); Schnabel, Jürgen, D-74211 Leingarten (DE); Gutsch, Henrik, Dr., D-74081 Heilbronn (DE)
(74) Vertreter: Maute, Hans-Jürgen, Dipl.-Ing.

(56) Entgegenhaltungen:
- PATENT ABSTRACTS OF JAPAN vol. 013, no. 184 (E-751), 28.April 1989 & JP-A-01 008719 (NEC CORP), 12.Januar 1989

## Beschreibung

Die Erfindung betrifft einen Schalter nach dem Oberbegriff des Patentanspruchs 1.

Ein derartiger Schalter ist beispielsweise aus der JP-A-10 08 719 bekannt. Bei diesem Schalter ist die Drain-Source-Strecke eines MOS-Transistors parallel zur Basis-Emitter-Diode eines Bipolartransistors geschaltet und der Gate-Anschluß des MOS-Transistors mit dem Kollektor des Bipolartransistors verbunden. Die Basis-Emitter-Diode des Bipolartransistors wird, sobald die Kollektor-Emitter-Spannung des Bipolartransistors einen Schwellwert überschreitet, über den MOS-Transistor kurzgeschlossen. Durch diese Maßnahme wird der Bipolartransistor bei hohen Kollektor-Emitter-Spannungen in einen leitenden Zustand geschaltet. Bei den Schwellwert unterschreitenden Kollektor-Emitter-Spannungen ist der MOS-Transistor hingegen wirkungslos.

Mit einem derartigen ansteuerbaren Schalter läßt sich ein erster Schaltungsteil schaltbar mit einem zweiten Schaltungsteil verbinden. Falls beispielsweise der erste Schaltungsteil eine Stromquelle aufweist, kann diese bei Bedarf durch Ansteuerung des Schalters, mit dem zweiten Schaltungsteil verbunden werden. Der Bipolartransistor als Schaltelement des Schalters wird üblicherweise in Vorwärtsrichtung betrieben. Beim Inversbetrieb des Bipolartransistors (Betrieb in Rückwärtsrichtung), schaltet dieser nur so lange zuverlässig, solange seine Kollektor-Emitter-Spannung die Kollektor-Emitter-Durchbruchspannung nicht überschreitet. Sobald seine Kollektor-Emitter-Spannung diesen Wert überschreitet, bricht der Bipolartransistor durch: dies hat zur Folge, daß ein beachtlicher Leckstrom über den Bipolartransistor zum ersten Schaltungsteil abgeleitet werden kann und dort unerwünschte temporäre oder auch permanente Funktionsstörungen verursacht.

Der Erfindung liegt die Aufgabe zugrunde, einen Schalter gemäß des Oberbegriffs des Anspruchs 1 anzugeben, der einen einfachen Aufbau und, in Rückwärtsrichtung betrieben, eine hohe Spannungsfestigkeit aufweist. Diese Aufgabe wird erfindungsgemäß durch die Merkmale im Kennzeichen des Patentanspruchs 1 gelöst. Vorteilhafte Ausgestaltungen und Weiterbildungen ergeben sich aus den Unteransprüchen.

Der erfindungsgemäße Schalter, der einen ersten Schaltungsteil mit einem zweiten Schaltungsteil verbindet, weist ein erstes Schaltelement - einen Bipolartransistor, vorzugsweise einen npn-Transistor - und ein zweites Schaltelement - einen Schalttransistor, vorzugsweise einen MOS-Transistor - auf. Die Basis des Bipolartransistors ist mit dem ersten Schaltanschluß des Schalttransistors und der Kollektor des Bipolartransistors mit dem zweiten Schaltanschluß des Schalttransistors verbunden. Der Steueranschluß des Schalttransistors ist an eine Steuersignalquelle, vorzugsweise über den Emitter des Bipolartransistors an den Eingang des mit dem Emitter verbundenen zweiten Schaltungsteils, angeschlossen. Die Verbindung des Steueranschlusses des Schalttransistors mit dem Emitter des Bipolartransistors erfolgt vorzugsweise über einen Entkopplungswiderstand. Sobald der Bipolartransistor invers betrieben wird - beim npn-Transistor ist das der Fall, wenn das Emitterpotential das Kollektorpotential überschreitet -, wird der Schalttransistor leitend. Basis und Kollektor des Bipolartransistors werden auf diese Art niederohmig miteinander verbunden. Durch diese niederohmige Verbindung erreicht man, daß die Kollektor-Emitter-Durchbruchspannung im wesentlichen von der Basis-Emitter-Durchbruchspannung bestimmt wird. Letztere liegt höher als die Kollektor-Emitter-Durchbruchspannung des Bipolartransistors mit unbeschalteter Basis, so daß dessen maximal zulässige Kollektor-Emitter-Spannung beim Inversbetrieb erhöht wird.

Wird der Schalttransistor des Schalters als MOS-Transistor ausgeführt, wird hierzu vorzugsweise ein Hochvolt-NMOS-Transistor eingesetzt. Ein derartiger Hochvolt-NMOS-Transistor unterliegt zumindest an seinem Drain-Anschluß nicht den Spannungsbeschränkungen herkömmlicher MOS-Transistoren.

Bei MOS-Transistoren ist es u. U. erforderlich, den Gate-Anschluß vor zu hohen Spannungen zu schützen. Dieses erfolgt vorzugsweise mit einer mit dem Gate-Anschluß verbundenen Z-Diode, die einen Anstieg des Gate-Potentials auf für den Betrieb des MOS-Transistors M₁₀ unzulässige Werte verhindert. Die Entkopplung des Gateund des Emitter-Potentials, die insbesondere bei leitender Z-Diode erwünscht ist, erfolgt vorzugsweise mit einem zwischen den Gate-Anschluß des MOS-Transistors und Emitter-Anschluß des Bipolartransistors geschalteten Entkopplungswiderstand.

Aufgrund seines einfachen Aufbaus ist der erfindungsgemäße Schalter platzsparend und kostengünstig in einen IC integrierbar.

Der Schalter ist überall dort einsetzbar, wo beim Inversbetrieb eines Bipolartransistors hohe Kollektor-Emitter-Spannungen auftreten können.

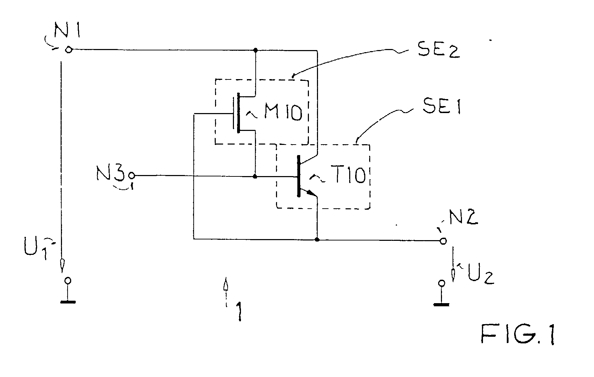

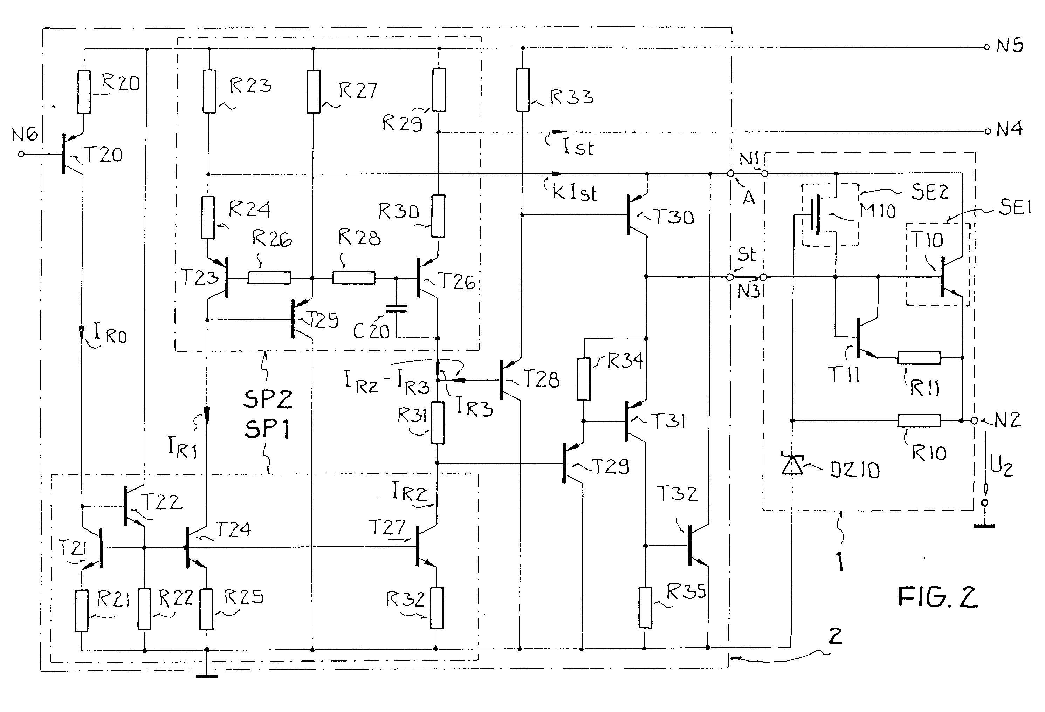

Anhand der Figuren 1 und 2 wird die Erfindung im folgenden näher beschrieben. Es zeigen:
Figur 1 ein erstes Ausführungsbeispiel,
Figur 2 ein weiteres Ausführungsbeispiel.

Aus Figur 1 wird die Anordnung eines nur ein erstes Schaltelement SE1 und ein zweites Schaltelement SE2 aufweisenden erfindungsgemäßen Schalters 1 ersichtlich. Beim ersten Schaltelement SE1 handelt es sich um den als npn-Transistor ausgeführten Bipolartransistor T₁₀, beim zweiten Schaltelement SE2 um den als MOS-Transistor M₁₀ bezeichneten und als Hochvolt-NMOS-Transistor ausgebildeten Schalttransistor M₁₀. Der Drain-Anschluß des MOS-Transistors M₁₀ und der Kollektor-Anschluß des Bipolartransistors T₁₀ sind mit dem ersten Anschlußknoten N1 des Schalters 1 verbunden. Der Gate-Anschluß des MOS-Transistors M₁₀ und der Emitter des Bipolartransistors T₁₀ sind mit dem zweiten Anschlußknoten N2 des Schalters 1 kontaktiert. Der Source-Anschluß des MOS-Transistors M₁₀ und der Basis-Anschluß des Bipolartransistors T₁₀ sind an den dritten Anschlußknoten N3 des Schalters 1 angeschlossen.

Im Vorwärtsbetrieb ist der MOS-Transistor M₁₀ wirkungslos; er sperrt, da sein Gate-Potential auf dem Emitter-Potential, d. h. auf dem niedrigsten Potential, liegt.

Im gesperrten Zustand, d. h. bei gesperrtem Bipolartransistor T₁₀, kann aufgrund der mit dem ersten und zweiten Anschlußknoten N1 und N2 verbundenen Schaltungsteile, die am Anschlußknoten N2 abfallende Spannung U₂ den Wert der am Anschlußknoten N1 anliegenden Spannung U₁ überschreiten. Der Bipolartransistor T₁₀ befindet sich dann im Inversbetrieb und der MOS-Transistor M₁₀ im leitenden Zustand. Folglich sind der Kollektor und die Basis des Bipolartransistors T₁₀ niederohmig miteinander verbunden. Aus diesem Grunde wird der Wert der Kollektor-Emitter-Durchbruchspannung des Bipolartransistors T₁₀ im wesentlichen durch die Durchbruchspannung seiner Basis-Emitter-Diode bestimmt.

Die Figur 2 zeigt den Schalter 1 und den damit verbundenen, als Strommultiplizierer 2 ausgeführten ersten Schaltungsteil. Der Schalter 1 ist über den Anschlußknoten N1 mit dem Ausgang A des Strommultiplizierers 2 und über den Anschlußknoten N3 mit dem Steuerausgang St des Strommultiplizierers 2 verbunden. Der Anschlußknoten N2 des Schalters 1 ist an einen in der Figur 2 nicht gezeigten zweiten Schaltungsteil, der den am Ausgang A des Strommultiplizierers anstehenden Strom aufnimmt, angeschlossen. Der Anschlußknoten N4 des Strommultiplizierers 2 ist als ein Steueranschluß ausgebildet, über den der in den Anschlußknoten N1 des Schalters 1 eingespeiste Strom - der Multiplikationsstrom kI_{St} - eingestellt wird. Der Multiplikationsstrom kI_{St} ist proportional zu dem aus dem Anschlußknoten N4 entzogenen Steuerstrom I_{St}. Der Anschlußknoten N5 ist ein mit einer Versorgungsquelle verbundener Versorgungsanschluß und der Anschlußknoten N6 ist ein weiterer Steueranschluß, der zur Arbeitspunkteinstellung des Strommultiplizierers 2 dient.

Beim Schalter 1 aus Figur 2 handelt es sich um eine erweiterte Version des Schalters 1 aus Figur 1. Der Gate-Anschluß des MOS-Transistors M₁₀ ist mit der Kathode einer Z-Diode DZ₁₀ verbunden. Auf diese Art wird das Gate-Potential auf für den Betrieb des MOS-Transistors zulässige Werte begrenzt. Mit dem zwischen den Gate-Anschluß des MOS-Transistors M₁₀ und den Emitter-Anschluß des Bipolartransistors T₁₀ geschalteten Entkopplungswiderstand R₁₀ wird das Gate-Potential des MOS-Transistors M₁₀ vom Emitter-Potential des Bipolartransistors T₁₀, d. h. von der Spannung U₂, entkoppelt. Die Basis und der Emitter des Bipolartransistors T₁₀ sind über einen als Diode geschalteten Transistor T₁₁ und einen mit diesem in Reihe geschalteten Ableitwiderstand R₁₁ miteinander verbunden.

Der Strommultiplizierer 2 weist zwei Stromspiegel SP1 und SP2 auf. Der Referenzstrom I_{R0} ist über einen am Anschlußknoten N6 in die Basis des Transistors T₂₀ einzuspeisenden Strom variierbar. Der als Spiegelstromsenke des Stromspiegels SP1 beschaltete npn-Transistor T₂₁ nimmt diesen Referenzstrom auf. Da es sich im vorliegenden Fall bei den beiden Widerständen R₂₅ und R₃₂ um gleich große Widerstände und bei den beiden als Spiegelstromquellen beschalteten Transistoren T₂₄ und T₂₇ um gleichartige npn-Transistoren handelt, sind die beiden gespiegelten - im folgenden mit Ruhestrom I_{R1} und I_{R2} bezeichneten - Ströme gleich groß und proportional zum Referenzstrom I_{R0}. Der als Spiegelstromsenke des Stromspiegels SP2 beschaltete pnp-Transistor T₂₃ nimmt den Ruhestrom I_{R1} auf. Der pnp-Transistor T₂₆ ist als Spiegelstromquelle des Stromspiegels SP2 ausgeführt. Der von ihm gelieferte Strom - der Spiegelstrom I_{R3} ist proportional zum Ruhestrom I_{R1}. Der Proportionalitätsfaktor - das Spiegelverhältnis - dieses Stromspiegels SP2 ist gleich 1, sofern dem Anschlußknoten N4 kein Steuerstrom I_{St} entzogen wird, d. h., solange der mit den Widerständen R₂₉ und R₃₀ gebildete Spannungsteiler nicht belastet wird. Sobald dieser Spannungsteiler belastet wird, mit anderen Worten, sobald der Steuerstrom I_{St} größer als Null wird, ändert sich das Emitter-Potential des Transistors T₂₆. Infolgedessen wird das Spiegelverhältnis des Stromspiegels SP2 und somit auch der Spiegelstrom I_{R3} verringert. Da der Spiegelstrom I_{R3} infolgedessen kleiner als die beiden gleich großen Ruheströme I_{R2} und I_{R1} geworden ist, kann ein Basisstrom I_{R2} - I_{R3} aus dem pnp-Transistor T₂₈ in den Widerstand R₃₁ fließen. Der dadurch leitend gewordene Transistor T₂₈ nimmt daraufhin den Basisstrom des pnp-Transistors T₃₀ auf. Dieser wird hierdurch leitend und liefert über den Steuerausgang St des Strommultiplizierers dem Bipolartransistor T₁₀ einen Basisstrom, so daß auch der in den leitenden Zustand übergeht. Letzterer belastet den mit den Widerständen R₂₃ und R₂₄ gebildeten und mit dem Ausgang A des Strommultiplizierers 2 verbundenen Spannungsteiler. Infolgedessen wird das Emitterpotential des Transistors T₂₃ zu geringeren Spannungen verschoben und somit das Stromspiegelverhältnis des Stromspiegels SP2 vergrößert. Aufgrund der mit dieser Rückkopplung gebildeten Regelschleife stellt sich der aus dem Spannungsteiler R₂₃, R₂₄ hinausfließende Multiplikationsstrom kI_{St} auf einen zum Steuerstrom I_{St} proportionalen Wert ein. Der Proportionalitätsfaktor hängt von den gewählten Widerstandswerten der Widerstände R₂₃, R₂₄, R₂₉ und R₃₀ ab. Der an die Basis und den Kollektor des Transistors T₂₆ angeschlossene Kondensator C₂₀ dient zur Unterdrückung der Schwingungsneigung der Regelschleife.

Falls, aufgrund des zweiten mit dem Anschlußknoten N2 verbundenen Schaltungsteils, der Multiplikationsstrom kI_{St} aus diesem Knoten nicht hinausfließen kann, nimmt die Kollektor-Emitter-Spannung des Transistors T₃₀ ihren minimalen Wert, der etwa so groß wie die am Widerstand R₃₁ abfallende Spannung ist, an. Das Kollektor-Potential des Transistors T₃₀ und folglich auch die Emitter-Potentiale der beiden pnp-Transistoren T₂₉ und T₃₁ werden dadurch angehoben; die Transistoren T₂₉ und T₃₁ werden hierdurch leitend. Infolgedessen erhält auch der npn-Transistor T₃₂ einen Basisstrom, so daß er seinerseits leitend geworden, den Multiplikationsstrom kI_{St} aufnimmt und gegen Masse ableitet. Auf diese Weise wird sichergestellt, daß sich die Belastung der mit dem Anschlußknoten N5 zu verbindenden Versorgungsquelle nicht in Abhängigkeit des aus dem Knoten N2 hinausfließenden Stromes ändert. Das ist insbesondere dann erforderlich, wenn die Versorgungsquelle gleichzeitig auch eine Signalquelle ist, bei der eine Laständerung auch eine Signaländerung zur Folge hätte.

## Patentansprüche

1. Schalter (1)
- mit einem als Bipolartransistor (T₁₀) ausgebildeten ersten Schaltelement (SE1), das kollektorseitig mit einem einen ersten Schaltanschluß bildenden ersten Anschlußknoten (N1), verbunden ist, emitterseitig mit einem einen zweiten Schaltanschluß bildenden zweiten Anschlußknoten (N2) verbunden ist, und basisseitig mit einem einen Steueranschluß bildenden dritten Anschlußknoten (N3), über den der Schalter (1) ansteuerbar ist, verbunden ist,
- und mit einem als Schalttransistor (M₁₀) ausgebildeten zweiten Schaltelement (SE2), das einen ersten Schaltanschluß, einen mit der Basis des Bipolartransistor (T₁₀) verbundenen zweiten Schaltanschluß und einen Steueranschluß aufweist,
dadurch gekennzeichnet,
- daß der erste Anschlußknoten (N1) an den Ausgang eines ersten Schaltungsteils und der zweite Anschlußknoten (N2) an den Eingang eines zweiten Schaltungsteils angeschlossen ist,
- und daß das zweite Schaltelement (SE2) mit seinem ersten Schaltanschluß an den Kollektor des Bipolartransistors (T₁₀) und mit seinem Steueranschluß an eine Steuersignalquelle angeschlossen ist, über die es beim Inversbetrieb des Bipolartransistors (T₁₀) in einen leitenden Zustand schaltbar ist.

2. Schalter nach Anspruch 1, dadurch gekennzeichnet, daß der Steueranschluß des Schalttransistors (M₁₀) mit dem Emitter des Bipolartransistor (T₁₀) und dem die Steuersignalquelle darstellenden zweiten Schaltungsteil verbunden ist.

## Claims

1. A switch (1)
- comprising a first switching element (SE1) which has the form of a bipolar transistor (T₁₀) and is connected by its collector to a first connecting node (N1) which forms a first switching terminal, by its emitter to a second connecting node (N2) which forms a second switching terminal, and by its base to a third connecting node (N3) which forms a control terminal and via which the switch (1) is controllable,
- and comprising a second switching element (SE2) which is formed by a switching transistor (M₁₀) and which has a first switching terminal, a second switching terminal connected to the base of the bipolar transistor (T₁₀), and a control terminal,
characterised in that
- the first connecting node (N1) is connected to the output of a first circuit component and the second connecting node (N2) is connected to the input of a second circuit component,
- and that the second switching element (SE2) is connected by its first switching terminal to the collector of the bipolar transistor (T₁₀) and is connected by its control terminal to a control signal source via which, in the case of the inverse operation of the bipolar transistor (T₁₀), it can be switched into a conductive state.

2. A switch according to Claim 1, characterised in that the control terminal of the switching transistor (M₁₀) is connected to the emitter of the bipolar transistor (T₁₀) and to the second circuit component which represents the control signal source.

## Revendications

1. Commutateur (1)
- équipé d'un premier élément de commutation (SE1) réalisé sous la forme d'un transistor bipolaire (T₁₀), qui est relié côté collecteur à un premier noeud de connexion (N1) formant une première borne de commutation, est relié côté émetteur à un second noeud de connexion (N2) formant une seconde borne de commutation, et est relié côté base à un troisième noeud de connexion (N3) formant une borne de commande, par l'intermédiaire de laquelle peut être commandé le commutateur (1),
- et d'un second élément de commutation (SE2) réalisé en tant que transistor de commutation (M₁₀), qui constitue une première borne de commutation, une seconde borne de commutation reliée à la base du transistor bipolaire (T₁₀) et une borne de commande,
caractérisé,
- en ce que le premier noeud de connexion (N1) est relié à la sortie d'une première partie de circuit et le second noeud de connexion (N2) est relié à l'entrée d'une seconde partie de circuit,
- et en ce que le second élément de commutation (SE2) est relié par sa première borne de commutation au collecteur du transistor bipolaire (T₁₀) et avec sa borne de commande à une source de signal de commande, par l'intermédiaire duquel il peut être commuté dans le cas du fonctionnement inverse du transistor bipolaire (T₁₀) en état conducteur.

2. Commutateur selon la revendication 1, caractérisé en ce que la borne de commande du transistor de commutation (M₁₀) est reliée à l'émetteur du transistor bipolaire (T₁₀) et à la seconde partie de circuit formant la source de signal de commande.
